(19) Europäisches Patentamt
European Patent Office
Office européen des brevets

(11)  **EP 1 979 125 B1**

(12)  **EUROPÄISCHE PATENTSCHRIFT**

(45) Veröffentlichungstag und Bekanntmachung des Hinweises auf die Patenterteilung:
**31.10.2012  Patentblatt 2012/44**

(51) Int Cl.:
*B23K 26/14* (2006.01)     *B23K 26/40* (2006.01)
*H01L 21/24* (2006.01)

(21) Anmeldenummer: 07703029.4

(22) Anmeldetag: **25.01.2007**

(86) Internationale Anmeldenummer:
**PCT/EP2007/000639**

(87) Internationale Veröffentlichungsnummer:
**WO 2007/085452 (02.08.2007 Gazette 2007/31)**

(54) **VERFAHREN ZUR PRÄZISIONSBEARBEITUNG VON SUBSTRATEN MITTELS EINES IN EINEN FLÜSSIGKEITSSTRAHL EINGEKOPPELTEN LASER**

PROCESS FOR THE PRECISION-PROCESSING OF SUBSTRATES BY MEANS OF A LASER COUPLED INTO A LIQUID STREAM

PROCÉDÉ D'USINAGE DE PRÉCISION DE SUBSTRATS AU MOYEN D'UN LASER INTRODUIT DANS UN JET DE LIQUIDE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **25.01.2006  DE 102006003606
25.01.2006  DE 102006003607**

(43) Veröffentlichungstag der Anmeldung:
**15.10.2008  Patentblatt 2008/42**

(60) Teilanmeldung:
**09011934.8 / 2 135 704**

(73) Patentinhaber:
• **Fraunhofer-Gesellschaft zur Förderung der angewandten Forschung e.V.
80686 München (DE)**
• **Albert-Ludwigs-Universität Freiburg
79088 Freiburg (DE)**

(72) Erfinder:
• **KRAY, Daniel
79112 Freiburg (DE)**
• **METTE, Ansgar
04105 Leipzig (DE)**
• **BIRO, Daniel
79106 Freiburg (DE)**
• **MAYER, Kuno
79114 Freiburg (DE)**
• **HOPMAN, Sybille
77972 Mahlberg (DE)**
• **REBER, Stefan, Dr.
79194 Gundelfingen (DE)**

(74) Vertreter: **Pfenning, Meinig & Partner GbR
Patent- und Rechtsanwälte
Theresienhöhe 13
80339 München (DE)**

(56) Entgegenhaltungen:
DE-A1- 3 643 284     DE-A1- 10 238 339
JP-A- 2005 034 889   US-A- 3 503 804
US-A- 5 762 493      US-A- 5 773 791
US-A1- 2003 062 126  US-B1- 6 777 647

**Beschreibung**

Die Erfindung betrifft ein Verfahren zur Präzisionsbearbeitung von Substraten, bei dem ein auf eine Substratoberfläche gerichteter und ein Bearbeitungsreagenz enthaltender Flüssigkeitsstrahl über die zu bearbeitenden Bereiche des Substrats geführt wird, wobei in den Flüssigkeitsstrahl ein Laserstrahl eingekoppelt wird. Ebenso wird eine zur Durchführung des Verfahrens geeignete Vorrichtung beschrieben. Verwendung findet das Verfahren für unterschiedliche Prozessschritte bei der Herstellung von Solarzellen.

Die Herstellung von Solarzellen ist mit einer Vielzahl von Prozessschritten zur Präzisionsbearbeitung von Wafern verbunden. Hierzu zählen u.a. die Emitterdiffusion, die Aufbringung einer dielektrischen Schicht sowie deren Mikrostrukturierung, die Dotierung des Wafers, die Kontaktierung, die Aufbringung einer Keimschicht sowie deren Verdickung.

Hinsichtlich der Mikrostrukturierung für die Vorderseitenkontaktierung ist die Mikrostrukturierung von dünnen Siliciumnitrid-Schichten ($SiN_x$) die derzeit gängige Anwendung. Solche Schichten bilden gegenwärtig die Standard-Antireflexbeschichtung bei kommerziellen Solarzellen. Da diese Antireflexbeschichtung, die auch teilweise als Vorderseitenpassivierung der Solarzelle dient, vor der Vorderseitenmetallisierung aufgebracht wird, muss diese nicht leitende Schicht durch entsprechende Mikrostrukturierung lokal zum Auftragen der Metallkontakte direkt am Silicium-Substrat geöffnet werden.

Stand der Technik ist hierbei das Bedrucken von $SiN_x$-Schichten mit einer Glasfritte-haltigen Metallpaste. Diese wird zunächst getrocknet, wobei das organische Lösemittel ausgetrieben und dann bei hohen Temperaturen (etwa 900 °C) gefeuert wird. Dabei greift die Glasfritte die $SiN_x$-Schicht an, löst sie lokal auf und ermöglicht dadurch die Ausbildung eines Silizium-Metall-Kontaktes. Nachteilig an diesem Verfahren sind der hohe Kontaktwiderstand, der durch die Glasfritte verursacht wird ($> 10^{-3}\ \Omega cm^2$) und die erforderlichen hohen Prozesstemperaturen, welche sowohl die Qualität der Passivierungsschichten, als auch die des Siliziumsubstrats reduzieren können.

Eine vorbekannte schonende Möglichkeit, die $SiN_x$-Schicht lokal zu öffnen, besteht in der Anwendung der Photolithographie kombiniert mit nasschemischen Ätzverfahren. Dabei wird zunächst eine Photolackschicht auf den Wafer aufgebracht und diese über UV-Belichtung und Entwickeln strukturiert. Es folgt ein nasschemischer Ätzschritt in einem flusssäurehaltigen oder phosphorsäurehaltigen Chemikaliensystem, der das $SiN_x$ an den Stellen entfernt, an denen der Photolack geöffnet wurde. Ein großer Nachteil dieses Verfahrens sind der enorme Aufwand und die damit verbundenen Kosten. Zudem kann mit diesem Verfahren kein für die Solarzellenproduktion ausreichender Durchsatz erreicht werden. Bei einigen Nitriden kann zudem das hier beschriebene Verfahren nicht angewandt werden, da die Ätzraten zu gering sind.

Aus dem Stand der Technik ist es überdies bekannt, eine Passivierungsschicht aus $SiN_x$ mit Hilfe eines Laserstrahls durch rein thermische Ablation abzutragen (trockene Laserablation).

Ferner ist aus dem Stand der Technik (US 2003/0062126 A1) ein Apparat und ein Verfahren bekannt, das die Behandlung eines Halbleitersubstrates durch einen Laser beschreibt, worin ein kontinuierlicher Flüssigkeitsstrom auf dem Halbleitersubstrat dafür sorgt, dass Umformungen und Trümmer des Substrates vom Laserpunkt weggewaschen werden (nasse Laserablation).

Hinsichtlich der Dotierung der Wafer ist in der Mikroelektronik eine lokale Dotierung durch photolithografisches Strukturieren einer aufgewachsenen $SiO_2$-Maske mit nachfolgender ganzflächiger Diffusion in einem Diffusionsofen Stand der Technik. Die Metallisierung wird durch Aufdampfen auf eine photolithografisch definierte Lackmaske mit nachfolgender Lösung des Lacks in organischen Lösemitteln erreicht. Dieses Verfahren hat den Nachteil eines sehr großen Aufwandes, des hohen Zeit- und Kostenbedarfs sowie der ganzflächigen Erhitzung des Bauteils, die eventuell weitere vorhandene Diffusionsschichten verändern sowie die elektronische Qualität des Substrats verschlechtern kann.

Eine lokale Dotierung kann auch über Siebdruck einer selbstdotierenden (z.B. aluminiumhaltigen) Metallpaste mit nachfolgendem Trocknen und Feuern bei Temperaturen um 900°C erfolgen. Der Nachteil dieses Verfahrens ist die hohe mechanische Belastung des Bauteils, die teuren Verbrauchsmaterialien sowie die hohen Temperaturen, denen das gesamte Bauteil ausgesetzt wird. Weiterhin sind hiermit nur Strukturbreiten $> 100\ \mu m$ möglich.

Ein weiteres Verfahren ("vergrabene Easiskontakte") nutzt eine ganzflächige $SiN_x$-Schicht, öffnet diese lokal mittels Laserstrahlung und diffundiert dann die Dotierschicht im Diffusionsofen. Durch die $SiN_x$-Maskierung bildet sich nur in den lasergeöffneten Bereichen eine hoch dotierte Zone. Die Metallisierung wird nach dem Rückätzen des entstehenden Phosphorsilikatglases (PSG) durch stromlose Abscheidung in einer metallhaltigen Flüssigkeit gebildet. Nachteil dieses Verfahrens ist die durch den Laser eingebrachte Schädigung sowie der notwendige Ätzschritt, um das PSG zu entfernen. Zudem besteht das Verfahren aus einigen Einzelschritten, die viele Handling-Schritte erforderlich machen.

Ausgehend hiervon war es Aufgabe der vorliegenden Erfindung, die prozesstechnische Durchführung der einzelnen Verfahrensschritte zur Präzisionsbearbeitung von Substraten, insbesondere Wafern, zu vereinfachen und gleichzeitig eine höhere Präzision dieser Prozessschritte zu ermöglichen.

Diese Aufgabe wird durch das Verfahren mit den Merkmalen des Anspruchs 1 gelöst. Die weiteren abhängigen Ansprüche zeigen vorteilhafte Weiterbildungen auf.

Erfindungsgemäß wird ein Verfahren zur Präzisionsbearbeitung von Substraten bereitgestellt, bei dem ein auf eine Substratoberfläche gerichteter und ein Bearbeitungsreagenz enthaltender Flüssigkeitsstrahl über die zu bearbeitenden Bereiche des Substrates geführt wird. Wesentliches Merkmal des erfindungsgemäßen Verfahrens ist es dabei, dass in den Flüssigkeitsstrahl ein Laserstrahl eingekoppelt wird und dass bei der Präzisionsbearbeitung mit einem Dotierstoff als Bearbeitungsreagenz eine zumindest bereichsweise Emitterdiffusion eines Dotierstoffs in einen Silizium-Wafer als Substrat durchgeführt wird.

Das erfindungsgemäße Verfahren bedient sich eines technischen Systems, bei dem ein Flüssigkeitsstrahl, der mit verschiedenen Chemikaliensystemen bestückt sein kann, als flüssiger Lichtleiter für einen Laserstrahl dient. Der Laserstrahl wird über eine spezielle Einkopplungsvorrichtung in den Flüssigkeitsstrahl eingekoppelt und durch interne Totalreflexion geführt. Auf diese Weise wird eine zeit- und ortgleiche Zufuhr von Chemikalien und Laserstrahl zum Prozessherd garantiert. Das Laserlicht nimmt dabei verschiedene Aufgaben wahr: Zum einen ist es in der Lage, an der Auftreffstelle auf der Substratoberfläche diese lokal aufzuheizen, optional dabei zu schmelzen und im Extremfall zu verdampfen. Durch das zeitgleiche Auftreffen von Chemikalien auf die beheizte Substratoberfläche können chemische Prozesse aktiviert werden, die unter Standardbedingungen nicht ablaufen, weil sie kinetisch gehemmt oder thermodynamisch ungünstig sind. Neben der thermischen Wirkung des Laserlichts ist auch eine photochemische Aktivierung möglich, dahingehend, dass das Laserlicht an der Oberfläche des Substrats beispielsweise Elektronen-Lochpaare generiert, die den Ablauf von Redoxreaktionen in diesem Bereich fördern oder gar erst ermöglichen können.

Der Flüssigkeitsstrehl sorgt neben der Fokussierung des Laserstrahls und der Chemikalienzufuhr auch für eine Kühlung der randständigen Bereiche des Prozessherds und für einen schnellen Abtransport der Reaktionsprodukte. Letztgenannter Aspekt ist eine wichtige Voraussetzung für die Förderung und Beschleunigung schnell ablaufender chemischer (Gleichgewichts-)Prozesse. Die Kühlung der randständigen Bereiche, welche nicht in die Reaktion involviert und vor allem dem Materialabtrag nicht unterworfen sind, können durch den Kühleffekt des Strahls vor thermischen Spannungen und daraus resultierenden kristallinen Schädigungen geschützt werden, was ein schädigungsarmes oder schädigungsfreies Strukturieren der Solarzellen ermöglicht. Darüber hinaus verleiht der Flüssigkeitsstrahl den zugeführten Stoffen durch seine hohe Fließgeschwindigkeit einen erheblichen mechanischen Impuls, der besonders dann wirksam wird, wenn der Strahl auf eine geschmolzene Substratoberfläche trifft.

Laserstrahl und Flüssigkeitsstrahl bilden zusammen ein neues Prozesswerkzeug, das in seiner Kombination prinzipiell den Einzelsystemen, aus denen es besteht, überlegen ist.

Sämtliche chemischen Prozesse, die bei der Mikrostrukturierung, Dotierung oder Metallisierung von Siliziumsolarzellen ablaufen, finden unter erhöhten Temperaturen statt. Das bedeutet im Gegenzug, dass die dazu erforderlichen Chemikalien unter Standardbedingungen nicht oder nur sehr schlecht reagieren.

$SiN_x$, das vorwiegend als Antireflexschicht auf Siliziumsolarzellen eingesetzt wird, kann selbst unter für Flüssigkeiten sehr hohen Temperaturen (über 150°C) nur mit sehr geringen Ätzraten von nur einigen 100 nm bis wenige $\mu$m pro Stunde geätzt werden. Angreifendes Ätzteilchen ist in der Regel das Proton, das verschiedenen Säuren entstammen kann; allerdings wird aufgrund der zum Ätzprozess erforderlichen, hohen Temperaturen vorwiegend konzentrierte Phosphorsäure eingesetzt, deren Siedepunkt bei ca. 180°C liegt, womit sie unter allen gängigen, kommerziell günstig erhältlichen, technischen Säuren den höchsten Siedepunkt besitzt. Die Ätzreaktion verläuft nach dem Schema:

$$3\ Si_3N_4 + 27\ H_2O + 4\ H_3PO_4 \rightarrow 4\ (NH_4)_3PO_4 + H_2SiO_3$$

Klassische Nickel-Galvanisierbäder arbeiten ab Temperaturen von mindestens 70°C, meistens jedoch - je nach Zusammensetzung - erst ab 90 - 100°C effektiv.

Die Bildung des Phosphorsilicatglases aus Phosphorylchlorid $POCl_3$ oder Phosphorsäure mit anschließender Phosphordiffusion erfolgt bei Temperaturen über 800°C.

Vorzugsweise ist das Substrat ausgewählt aus der Gruppe bestehend aus Silicium, Glas, Metall, Keramik, Kunststoff und deren Verbundstoffen. Das Substrat kann dabei vorzugsweise an der zu behandelnden Oberfläche auch eine oder mehrere Beschichtungen aufweisen. Hierzu zählen Beschichtungen aus $SiN_x$, $SiO_2$, $SiO_x$, $MgF_2$, $TiO_2$ oder $SiC_x$.

Vorzugsweise wird ein möglichst laminarer Flüssigkeitsstrahl zur Durchführung des Verfahrens verwendet. Der Laserstrahl kann dann in besonders effektiver Weise durch Totalreflexion in dem Flüssigkeitsstrahl geführt werden, so dass letzterer die Funktion eines Lichtleiters erfüllt. Das Einkoppeln des Laserstrahls kann z.B. durch ein zu einer Strahlrichtung des Flüssigkeitsstrahls senkrecht orientiertes Fenster in einer Düseneinheit erfolgen. Das Fenster kann dabei auch als Linse zum Fokussieren des Laserstrahls ausgeführt sein. Alternativ oder zusätzlich kann auch eine von dem Fenster unabhängige Linse zum Fokussieren oder Formen des Laserstrahls verwendet werden. Die Düseneinheit kann dabei bei einer besonders einfachen Ausführung der Erfindung so ausgelegt sein, dass die Flüssigkeit von einer Seite oder von mehreren Seiten in zur Strahlrichtung radialer Richtung zugeführt wird.

Als verwendbare Lasertypen sind bevorzugt:

Verschiedene Festkörperlaser, insbesondere die kommerziell häufig eingesetzten Nd-YAG-Laser der Wellenlänge 1064 nm, 532 nm, 355 nm, 266 nm und 213 nm, Diodenlaser mit Wellenlängen < 1000 nm, Argon-Ionen-Laser der Wellenlänge 514 bis 458 nm und Excimer-Laser (Wellenlängen: 157 bis 351 nm).

Tendenziell steigt die Qualität der Mikrostrukturierung mit sinkender Wellenlänge an, weil dabei zunehmend die durch den Laser induzierte Energie in der Oberflächenschicht immer besser an der Oberfläche konzentriert wird, was tendenziell zur Verringerung der Wärmeeinflusszone und damit verbunden zur Verringerung der kristallinen Schädigung im Material, vor allem im phosphordotierten Silizium unterhalb der Passivierungsschicht führt.

Als besonders effektiv erweisen sich in diesem Zusammenhang blaue Laser und Laser im nahen UV-Bereich (z.B. 355 nm) mit Pulslängen im Femtosekunden- bis Nanosekundenbereich. Durch den Einsatz insbesondere kurzwelligen Laserlichts besteht darüber hinaus die Option einer direkten Generation von Elektronen/Loch-Paaren im Silizium, die für den elektrochemischen Prozess bei der Nickelabscheidung genutzt werden können (photochemische Aktivierung). So können beispielsweise durch Laserlicht generierte freie Elektronen im Silizium zusätzlich zum oben bereits beschriebenen Redoxprozess der Nickel-Ionen mit phosphoriger Säure direkt zur Reduktion von Nickel an der Oberfläche betragen. Diese Elektronen/Loch-Generation kann durch permanente Beleuchtung der Probe mit definierten Wellenlängen (insbesondere im nahen UV mit $\lambda \leq 355$ nm) während des Strukturierungsprozesses permanent aufrechterhalten werden und den Metallkeimbildungsprozess nachhaltig fördern.

Hierzu kann die Solarzelleneigenschaft ausgenutzt werden, um über den p-n-Übergang die Überschlussladungsträger zu trennen und damit die n-leitende Oberfläche negativ aufzuladen.

Eine weitere bevorzugte Variante des erfindungsgemäßen Verfahrens sieht vor, dass der Laserstrahl in zeitlicher und/oder räumlicher Pulsform aktiv eingestellt wird. Hierzu zählt die Flattop-Form, ein M-Profil oder ein Rechteckpuls.

Die erfindungsgemäße Präzisionsbearbeitung umfasst eine Emitterdiffusion eines Dotierstoffs in einem Silicium-Wafer als Substrat.

Durch die lokale Erhitzung des Substrats durch den Laserstrahl können innerhalb dieses begrenzten Bereiches die für die Diffusion im Substrat notwendigen Temperaturen erzeugt und der Dotierstoff eingetrieben werden. Da die Diffusion bei geringen Temperaturen nur extrem langsam erfolgt, wird somit nur im Bereich der auftreffenden Laserstrahlung eine Dotierung des Substrats erreicht, während in den angrenzenden Bereichen des Substrats keine Veränderung erzeugt wird.

Durch das erfindungsgemäße Verfahren wird eine Kristallschädigung bei lokaler Dotierung vermieden, da durch die Laserstrahlung die Oberflächentemperatur unterhalb des Schmelzpunktes gehalten werden kann. Weiterhin wird eine Temperaturbelastung des gesamten Substrats vermieden.

Hinsichtlich der im Flüssigkeitsstrahl enthaltenen Dotierstoffe sind alle aus dem Stand der Technik bekannten Dotierstoffe einsetzbar. Besonders bevorzugt sind hier Dotierstoffe ausgewählt aus der Gruppe bestehend aus Phosphor, Bor, Indium, Gallium und Mischungen hiervon.

Eine weitere bevorzugte Variante sieht vor, dass vor oder nach einem der Schritte zur Präzisionsbearbeitung des Substrates eine dielektrische Schicht auf dem Substrat abgeschieden wird. Diese Schicht dient der Passivierung der Oberfläche des Substrats.

Die dielektrische Schicht ist dabei vorzugsweise ausgewählt aus der Gruppe bestehend aus $SiN_x$, $SiO_2$, $SiO_x$, $MgF_2$, $TiO_2$ und $SiC_x$.

Eine weitere bevorzugte Variante des erfindungsgemäßen Verfahrens sieht vor, dass bei der Präzisionsbearbeitung eine Mikrostrukturierung der zuvor beschriebenen dielektrischen Schicht erfolgt.

Die Mikrostrukturierung beruht auf einer Öffnung der dielektrischen Schicht, die vorzugsweise durch Behandlung mit einem trockenen Laser oder einem wasserstrahlgeführten Laser oder einem ein Ätzmittel enthaltenden flüssigkeitsstrahlgeführten Laser geöffnet wird.

Es ist dabei bevorzugt, dass die dielektrische Schicht durch Behandlung mit dem das Bearbeitungsreagenz enthaltenden flüssigkeitsstrahlgeführten Laser geöffnet wird und das Bearbeitungsreagenz ein Ätzmittel ist, das auf die dielektrische Schicht eine stärker ätzende Wirkung als auf das Substrat besitzt. Als Bearbeitungsreagenz wird dabei bevorzugt ein Ätzmittel ausgewählt, mit dem auch Schäden im Substrat nachgeätzt werden können. Bevorzugte Ätzmittel sind ausgewählt aus der Gruppe bestehend aus phosphorhaltigen Säuren, z.B. $H_3PO_4$ und $H_3PO_3$, KOH, HF/HNO$_3$, Chlorverbindungen und Schwefelsäure.

Der Flüssigkeitsstrahl kann besonders bevorzugt aus reiner oder hoch konzentrierter Phosphorsäure oder auch verdünnter Phosphorsäure gebildet werden. Die Phosphorsäure kann z.B. in Wasser oder einem anderen geeigneten Lösungsmittel verdünnt und in unterschiedlicher Konzentration verwendet werden. Auch können Zusätze zur Veränderung von pH-Wert (Säuren oder Laugen), Benetzungsverhalten (z.B. Tenside) oder Viskosität (z.B. Alkohole) zugesetzt werden. Besonders gute Ergebnisse werden bei Verwendung einer Flüssigkeit erzielt, die Phosphorsäure mit einem Anteil von 50 bis 85 Gew.-% enthält. Damit lässt sich insbesondere eine zügige Bearbeitung der Oberflächenschicht ohne Beschädigung des Substrats und umliegender Bereiche realisieren.

Durch die erfindungsgemäße Mikrostrukturierung wird mit sehr geringem Aufwand zweierlei erreicht.

Einerseits kann die Oberflächenschicht in den genannten Bereichen vollständig abgetragen werden, ohne dass das Substrat dabei beschädigt wird, weil die Flüssigkeit auf letzteres eine weniger (vorzugsweise gar keine) ätzende Wirkung hat. Zugleich wird durch das lokale Aufheizen der Oberflächenschicht in den abzutragenden Bereichen, wodurch vorzugsweise ausschließlich diese Bereiche aufgeheizt werden, ein gut lokalisiertes, auf diese Bereiche beschränktes Abtragen der Oberflächenschicht ermöglicht. Das ergibt sich aus der Tatsache, dass die ätzende Wirkung der Flüssigkeit typischerweise mit zunehmender Temperatur zunimmt, so dass eine Beschädigung der Oberflächenschicht in benachbarten, nicht aufgeheizten Bereichen durch evtl. dorthin gelangende Teile der ätzenden Flüssigkeit weitgehend vermieden wird.

Um eine möglichst vorteilhafte Metallkontaktierung mit möglichst geringem Kontaktwiderstand zu realisieren, weist in der vorliegenden Erfindung bei der Mikrostrukturierung der Flüssigkeitsstrahl zusätzlich zur ätzenden Flüssigkeit in flüssiger Form ein Reduktionsmittel und optional desweiteren ein Metallsalz auf. Vorteilhafterweise weisen dabei das Ätzmittel und das Reduktionsmittel ein und dasselbe chemische Element, z.B. Phosphor in unterschiedlichen Oxidationsstufen auf. In besonders vorteilhaften Ausführungsformen werden somit die folgenden Paare im Komponentensystem eingesetzt: Als ätzende Flüssigkeit $H_3PO_4$ und als Reduktionsmittel $H_3PO_3$; als ätzende Flüssigkeit $H_2SO_4$ und als Reduktionsmittel $H_2SO_3$; als ätzende Flüssigkeit $HNO_3$ und als Reduktionsmittel $HNO_2$. Vorteilhafterweise sorgen Zusätze von KF für eine definierte Menge freier Flusssäure, welche die Ätzrate auf das SiN noch steigert. Als Metallsalz lassen sich besonders vorteilhaft Salze des Silbers, des Nickel, des Zinn, des Pb, des Aluminium oder des Chrom einsetzen. Mit Hilfe des Reduktionsmittels ist eine hinsichtlich der Dotierstoffkonzentration höhere Dotierung der Emitterschicht bzw. Substratschicht möglich, was eine spätere, beispielsweise galvanische, Metallabscheidung verbessert und den Kontaktwiderstand reduziert. Bei Zusetzung eines Metallsalzes ist mit Hilfe des Reduktionsmittels an den erwärmten lokalen Oberflächenbereichen eine Reduktion der Metallionen zu elementarem Metall möglich, was zur Ausbildung von effektiven Abscheidekeimen für einen späteren Galvanisierungsprozess führt. Eine solche Deposition von Metallpartikeln führt somit ebenfalls dazu, dass ein Metallkontakt mit geringem Kontaktwiderstand ausgebildet werden kann.

Durch die solchermaßen verbesserten Metall-Kontaktierungen wird die Leitungsfähigkeit von auf diese Weise hergestellten Solarzellen verbessert, ohne dass sich ein erhöhter Bearbeitungsaufwand ergibt.

Bei typischen Anwendungen der erfindungsgemäßen Mikrostrukturierung wird die Oberflächenschicht eine Dicke von zwischen 1 nm und 300 nm haben. Das Substrat kann bei typischen Anwendungen des Verfahrens eine Schichtdicke von zwischen 25 μm und 800 μm haben. Damit ergäbe sich ein z.B. zur Herstellung von Solarzellen geeigneter Aufbau.

Gegenüber den aus dem Stand der Technik bekannten Mikrostrukturierungsprozessen können folgende Aspekte der vorliegenden Erfindung als vorteilhafte Weiterentwicklungen angesehen werden:

1) Das flüssigkeitsstrahlgeführte Laserverfahren ist maskenlos, d.h. es wird kein Aufbringen und Entfernen eine Maskierungsschicht benötigt.

2) Der Abtrag von Beschichtungen bzw. Substratmaterial erfolgt schädigungsfrei, d.h. es ist kein anschließendes Reinigen bzw. Nachätzen notwendig.

Gegenüber der reinen, trockenen Laserablation des Standes der Technik im Bereich der Mikrostrukturierung besitzt das erfindungsgemäße Verfahren folgende Vorteile:

- Der Materialabtrag von der Oberflächenschicht erfolgt hier sauberer als bei der trockenen, rein thermischen Ablation, weil dort verdampftes oder geschmolzenes Material, das einen sehr hohen Schmelz- und Siedepunkt besitzt, in gewissem Umfang an den kälteren Rändern des bearbeiteten Bereichs wieder abgeschieden wird. Der Einsatz von Ätzchemikalien vermindert oder verhindert vollständig diese unerwünschte Redeposition, indem das abgetragene Material in eine leicht vom Abtragsherd abtransportierbare Form, z.B. gasförmige oder gut lösliche Produkte, überführt wird.

- Der flüssigkeitsstrahl-geführte Laser nutzt den Kühleffekt des Flüssigkeitsstrahls, um die Wärmeeinflusszone um den Bearbeitungsbereich herum zu minimieren und damit thermische Schädigungen im Substrat zu reduzieren.

- Flüssigkeitsstrahl geführte Laser verfügen bezüglich des Abstands zwischen Laserquelle und Substrat über einen größeren Arbeitsbereich. Dies beruht im Wesentlichen auf folgendem Aspekt: Konvehtionelle Laserstrahlen sind konisch, d.h. sie besitzen einen Fokuspunkt. Der Arbeitsabstand ist auf strenge Grenzen um diesen Fokuspunkt beschränkt, da in ihm der Laserstrahl die höchste Intensität und den kleinsten Spot aufweist. Flüssigkeitsstrahlgeführte Laserstrahlen sind hingegen so lange fokussiert, solange der flüssige Lichtleiter bzw. Flüssigkeitsstrahl seine Laminarität beibehält. Dies ist üblicherweise über Strecken von mehreren Zentimetern der Fall. Ein Nachfokussieren, wie es bei konventionellen, trockenen Lasern nötig ist, vor allem wenn tiefere Gräben erzeugt werden sollen, erübrigt sich hier.

Gegenüber photo-galvanischen Verfahren mit konventionellen, trockenen Lasersystemen und stehender Ätzlösung besitzt die erfindungsgemäße Mikrostrukturierung mit einem flüssigkeitsstrahl-geführten Laser folgende Vorteile:

- Wird ein "trockener" Laserstrahl durch eine auf dem Substrat stehende, dieses bedeckende Flüssigkeitsschicht fokussiert, so werden bedeutende Mengen des Laserlichts in der Flüssigkeitsschicht gestreut, was einerseits einen deutlichen Leistungsverlust darstellt, andererseits die Fokussierbarkeit des Laserspots erheblich einschränkt. Eine solche Streuung wird bei einem flüssigkeitsstrahlgeführten Laser vermieden. Zwar bildet sich nach Aufstrahlen der Flüssigkeit auch hier über der Substratoberfläche ein Flüssigkeitsfilm aus (bedingt durch die abfließende Flüssigkeit vom Ätzherd), doch wird dieser durch den hohen Impuls des Flüssigkeitsstrahls praktisch vollständig verdrängt und spielt daher als Streumedium für das Laserlicht keine Rolle.

- Durch die hohen Strömungsgeschwindigkeiten an der Reaktionsstelle werden die sich bildenden Ätzprodukte schnell abtransportiert. Dieser Sachverhalt ist bei vielen chemischen Prozessen, deren Reaktionsgeschwindigkeiten einer Diffusionskontrolle unterliegen, von erheblicher Bedeutung, da er deren Reaktionsrate dadurch erhöht. Bei konventionellen Lasersystemen werden hingegen allein durch den Temperaturgradienten zwischen aufgeheizter Substratoberfläche und der darüber stehenden, kälteren Lösung Konvektionsströme erzeugt ("microstirring"), die wesentlich schwächere Durchmischungen der Lösung erzeugen als der Flüssigkeitsstrahl.

- Darüber hinaus ermöglicht der Flüssigkeitsstrahl zusätzlich eine Reinigung der Substratoberfläche von Verunreinigungen durch Fremdstoffe, z.B. Schwebstoffe aus der Luft, die an der Oberfläche physisorbiert sind.

Eine besonders bevorzugte Variante sieht vor, dass Mikrostrukturierung und Dotierung simultan durchgeführt werden. Eine weitere erfindungsgemäße Variante umfasst, dass bei der Präzisionsbearbeitung im Anschluss an die Mikrostrukturierung eine Dotierung des mikrostrukturierten Silicium-Wafers erfolgt und das Bearbeitungsreagenz einen Dotierstoff enthält.

Dies lässt sich dadurch realisieren, dass anstelle der den mindestens einen Dotierstoff enthaltenden Flüssigkeit eine mindestens eine das Festkörpermaterial ätzende Verbindung enthaltende Flüssigkeit verwendet wird. Diese Variante ist besonders bevorzugt, da in der gleichen Vorrichtung zunächst die Mikrostrukturierung und durch den Austausch der Flüssigkeiten anschließend die Dotierung durchgeführt werden kann. Alternativ kann die Mikrostrukturierung auch mittels eines Aerosol-Strahls durchgeführt werden, wobei bei dieser Variante nicht zwingend Laserstrahlung erforderlich ist, da vergleichbare Ergebnisse dadurch erreicht werden können, dass das Aerosol bzw. dessen Komponenten vorgeheizt werden.

Ebenso umfasst das erfindungsgemäße Verfahren als weitere Variante, dass bei der Präzisionsbearbeitung nur bereichsweise eine Dotierung im Substrat erzeugt wird, anschließend auf der Substratoberfläche befindliche Flüssigkeit eingetrocknet und das Substrat thermisch behandelt wird, so dass das Substrat eine schwache Flächendotierung und eine eingetriebene hohe Lokaldotierung aufweist.

Der verwendete Dotierstoff ist vorzugsweise ausgewählt aus der Gruppe bestehend aus Phosphorsäure, Phosphorige Säure, $POCl_3$, $PCl_3$, $PCl_5$, Borverbindungen, Galliumverbindungen und Mischungen hiervon.

Gegenüber den aus dem Stand der Technik bekannten Dotierprozessen können folgende Aspekte der vorliegenden Erfindung als vorteilhafte Weiterentwicklungen angesehen werden:

1) Das hier zu patentierende Verfahren erfordert kein Aufbringen der Phosphorquelle auf die zu dotierende Oberfläche vor dem eigentlichen Dotierschritt etwa durch vorherige Beschichtung der Substratoberfläche mit einem Phosphorglas. Phosphorquellenzufuhr und Diffusion können gleichzeitig in einem Einschritt-Prozess vorgenommen werden.

2) Beim Dotieren mit dem neuen Verfahren ist kein weiterer Temperierschritt zwingend erforderlich.

3) Es werden mit relativ geringem technischem Aufwand im Vergleich zu bisherigen Verfahren sehr hohe Dotierkonzentrationen (ca. $10^{21}$ P-Atome/cm$^3$) und damit verbunden geringe Kontaktwiderstände erreicht.

Nach einer weiteren Variante des erfindungsgemäßen Verfahrens umfasst die Präzisionsbearbeitung eine zumindest bereichsweise Aufbringung einer Keimschicht auf einem Silicium-Wafer. Hierbei handelt es sich somit um einen Metallisierungsschritt.

Bevorzugt ist es dabei, dass im Anschluss an die Dotierung eine Metallisierung der dotierten oberflächenbereiche durch Austausch der den Dotierstoff enthaltenden Flüssigkeit durch eine mindestens eine Metall-Verbindung enthaltende Flüssigkeit durchgeführt wird. Auch hier ist es wieder besonders einfach, durch Wechsel der entsprechenden Flüssigkeiten die Verfahrensschritte der Dotierung und Metallisierung sequentiell in der gleichen Vorrichtung durchzuführen.

Die Aufbringung kann dabei durch Nickel-Galvanisierung, Nickel-Laser-Verfahren, Inklet-Verfahren, Aerosol-Verfahren, Aufdampfen, Lasermikrosintern, Siebdruck und/oder Tampondruck erfolgen. Besonders bevorzugt ist es hierbei, dass die Aufbringung der Keimschicht mit dem das Bearbeitungsreagenz enthaltenden flüssigkeitsstrahlgeführten Laser durchgeführt wird, wobei das Bearbeitungsreagenz mindestens eine Metallverbindung enthält.

Vorzugsweise wird bei der Metallisierung als Metall-Verbindung eine Verbindung aus der Gruppe der Metalle bestehend aus Silber, Aluminium, Nickel, Titan, Molybdän, Wolfram und Chrom eingesetzt. Besonders bevorzugt wird als Metall-Verbindung Silbercyanid oder Silberacetat und deren Lösungen verwendet.

Wird bei der Aufbringung der Keimschicht ein Laserstrahl eingesetzt, so kann dieser die Metallisierung im Bereich des Auftreffpunkts des Flüssigkeitsstrahls auf der Oberfläche katalysieren. Die Metallisierung kann dabei so lange fortgeführt werden, bis die gewünschte Gesamtstärke erreicht ist oder aber nach dem Aufwachsen einer wenige Nanometer dünnen Schicht gestoppt und im Anschluss galvanisch verdickt werden.

Die zuletzt beschriebene Variante ermöglicht ein Gesamtverfahren, bei dem z.B. ein Silicium-Wafer in einer einzigen Bearbeitungsstation nur unter Austausch der eingesetzten Flüssigkeiten strukturiert, dotiert und metallisiert werden kann.

Vorzugsweise wird die Keimschicht auf den dotierten Bereichen des Silicium-Wafers aufgebracht.

Gegenüber den aus dem Stand der Technik bekannten Metallisierungsverfahren können vor allem folgende Aspekte als vorteilhafte Weiterentwicklungen bisheriger Prozesse betrachtet werden:

1) Mit dem neuen Verfahren können sowohl Öffnung der Nitridschichten, Dotierung und Bekeimung oder Beschichtung der hoch dotierten Bereiche gleichzeitig in einem einzigen Prozessschritt vollzogen werden. Vor allem die gleichzeitig zur Strukturierung des Nitrids ablaufende Dotierung mit ein und derselben apparativen Vorrichtung stellt eine vorteilhafte Weiterentwicklung gegenüber dem bisherigen BC-Solarzellen-Kontaktierungsprozess dar.

2) Durch geschickte Wahl der Dotier/Metallisierlösung kann sogar eine dem Dotieren/Metallisieren parallel verlaufende Schadensätze der gefertigten Gräben vorgenommen werden. Wie von Baumann et al. (2006) bereits gezeigt wurde, ermöglicht das LCE-Verfahren den schädigungsfreien Abtrag von Siliziummaterial in einem Schritt ohne weitere nachfolgende Schadensätze. Von diesem Vorteil wird beim vorliegenden Verfahren Gebrauch gemacht.

3) Durch den speziellen Mechanismus bei der Kontaktierung können die Kontaktqualitäten verbessert werden, die sich zum einen in einer besseren Haftung äußern, zum anderen in einer Verringerung des Kontaktwiderstands, bedingt durch Nickelsilicid-Bildung an den Kontaktflächen, wodurch ein weiterer Sintervorgang auch an dieser Stelle des Prozesses nicht mehr zwingend erforderlich ist.

4) Ebenso erspart die verwendete Apparatur ein zusätzliches Aufheizen der Dotier-/Metallisierlösungen.

Eine weitere bevorzugte Variante sieht vor, dass die Schritte zur Präzisionsbearbeitung des Substrates die Mikrostrukturierung, die Dotierung und die Aufbringung der Keimschicht umfassen, wobei diese einzelnen Schritte nacheinander oder parallel durchgeführt werden können.

Die bei diesen Prozessschritten verwendeten Reagenzien weisen deutliche chemische Parallelen auf: In allen drei Prozessschritten werden phosphorhaltige Substanzen eingesetzt, jedoch mit zum Teil unterschiedlichen Oxidationsstufen des Phosphors. Dieser besitzt in der Phosphorsäure die Oxidationsstufe +V während er im Hypophosphit die Oxidationszahl +I aufweist und dort entsprechend ein starkes Reduktionsmittel ist, während das Hydrogenphosphat-Ion weder eine starke Reduktions- noch Oxidationsneigung zeigt. Die Reduktionsneigung des Hypophosphits ist vom pH-Wert der Lösung abhängig; in basischen Lösungen ist sie höher als im neutralen oder sauren Milieu. Hingegen kommt die Ätzwirkung der Phosphorsäure auf das Siliziumnitrid nur in sauren Lösungen zur Geltung. Bei der Phosphorsilicatglasbildung ist der pH-Wert der verwendeten phosphorhaltigen Substanz weniger von Bedeutung als die Absättigung der Valenzen des Phosphors mit Sauerstoffatomen. Diese werden zur Netzwerkbildung im Phosphorsilicatglas benötigt, wo sie die Bindungsbrücken zwischen den Silizium- und den Phosphoratomen bilden. Entsprechend ist Phosphorsäure ein besserer Glasbildner als beispielsweise phosphorige Säure oder Hypophosphit. Die Verglasung des sauerstoffarmen Phosphorylchlorids erfolgt aus diesem Grund nur in einer Sauerstoff enthaltenden Atmosphäre.

Die Zusammensetzung der einzelnen Reaktionsmedien, die Chemie des Phosphors und seiner Sauerstoffverbindungen sowie die Tatsache, dass bei allen drei Prozessschritten erhöhte bis zum Teil sehr hohe Temperaturen erforderlich sind, ermöglicht eine Zusammenfassung der drei Prozessschritte: Nitridstrukturierung, Phosphordotierung und Metallisierung von Siliziumsolarzellen in einen einzigen Hochtemperaturschritt.

In einer weiteren bevorzugten Variante des erfindungsgemäßen Verfahrens wird nach der Aufbringung der Keimschicht eine Rückseitenkontaktierung aufgebracht. Dies kann besonders bevorzugt durch Aufdampfen oder Sputtern einer oder mehrerer Metallschichten (z.B. Aluminium, Silber oder Nickel) erfolgen. Ebenso ist es möglich, dass nach der Aufbringung der Keimschicht eine zusätzliche Rückseitenkontaktierung durch lasergefeuerte Rückseitenkontaktierung (LFC) aufgebracht wird.

Eine weitere bevorzugte Variante sieht vor, dass nach der Aufbringung der Keimschicht eine thermische Behandlung, insbesondere bei Temperaturen von 100 °C bis 900 °C für 0,5 bis 30 min, erfolgt. Diese thermische Behandlung kann z.B. durch Laser-Annealing mit Punkt- oder Linienfokus erfolgen.

In einer weiteren erfindungsgemäßen Präzisionsbearbeitung kann im Anschluss an das Aufbringen der Keimschicht eine Verdickung der Keimschicht erfolgen. Diese Verdickung erfolgt vorzugsweise durch galvanische Abscheidung, z.B. von Ag, oder durch stromlose Abscheidung, z.B. von Cu.

Besonders bevorzugt ist es, einen Gesamtprozess zur Herstellung von Solarzellen bereitzustellen, bei dem mehrere oder alle der zuvor genannten Verfahrensschritte nacheinander oder parallel durchgeführt werden. Somit ist ein Gesamtprozess möglich, bei dem eine Mikrostrukturierung, eine Dotierung, die Aufbringung einer Keimschicht und die Verdickung der Keimschicht erfolgen.

Eine Vorrichtung zur Durchführung eines Verfahrens beschriebener Art kann so ausgeführt sein, dass es eine Düseneinheit mit einem Fenster zum Einkoppeln eines Laserstrahls, einer Flüssigkeitszufuhr und einer Düsenöffnung umfasst, wobei die Düseneinheit gehalten ist von einer Führungsvorrichtung zum gesteuerten, vorzugsweise automatisierten, Führen der Düseneinheit über die zu strukturierende Oberflächenschicht. Zusätzlich umfasst die Vorrichtung typischerweise auch eine Laserstrahlquelle mit einer dem Fenster korrespondierend angeordneten Lichtaustrittsfläche, die beispielsweise durch ein Ende eines Lichtleiters gegeben sein kann. Alternativ oder zusätzlich kann eine Vorrichtung zur Durchführung eines erfindungsgemäßen Verfahrens eine Düse zum Erzeugen des Flüssigkeitsstrahls und eine Laserlichtquelle umfassen, wobei die Düse und die Laserlichtquelle von jeweils einer Führungsvorrichtung oder von einer gemeinsamen Führungsvorrichtung gehalten ist zum Führen der Düse und der Laserlichtquelle über dieselben Bereiche der zu strukturierenden Oberflächenschicht.

Das erfindungsgemäße Verfahren eignet sich insbesondere für verschiedene Verfahrensschritte in der Prozesskette zur Herstellung von Solarzellen. Hierzu gehört die Emitterdiffusion von Silicium-Wafern, ebenso wie die Mikrostrukturierung von Substraten, deren Dotierung und die Aufbringung von Keimschichten auf Silicium-Wafern.

Anhand der nachfolgenden Figur und Beispiele soll der erfindungsgemäße Gegenstand näher erläutert werden, ohne diesen auf die hier gezeigten speziellen Ausführungsformen einschränken zu wollen.

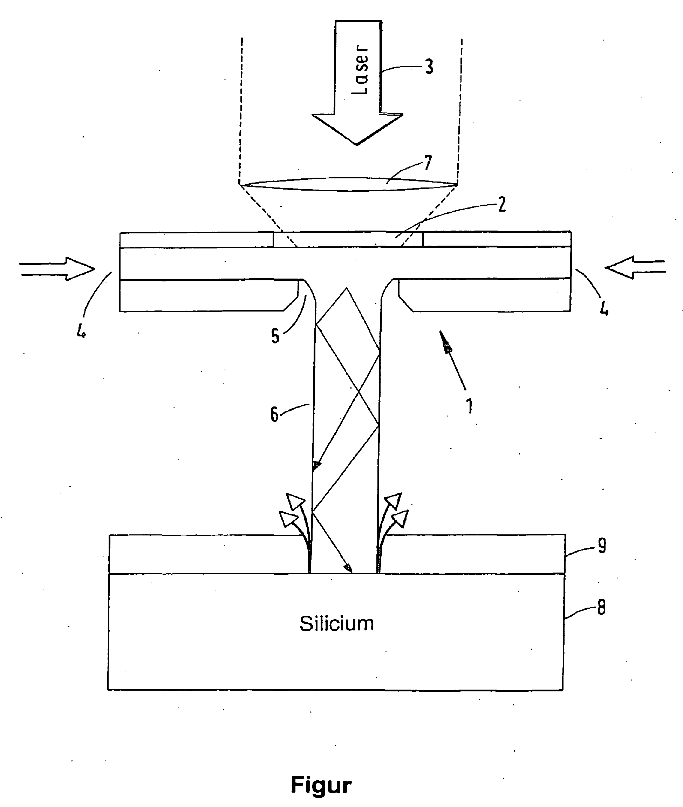

Die Figur zeigt eine Darstellung eines erfindungsgemäßen Verfahrens mit einem Schnitt durch ein mit einer Oberflächenschicht versehenes Substrat und eine erfindungsgemäße Vorrichtung.

In der Figur ist eine Düseneinheit 1 dargestellt, die ein Fenster 2 zum Einkoppeln eines Laserstrahls 3 sowie eine Flüssigkeitszufuhr 4 und eine Düsenöffnung 5 umfasst. Diese Düseneinheit dient zur Erzeugung eines Flüssigkeitsstrahls 6, in dem der eingekoppelte Laserstrahl 3 durch Totalreflexion geführt wird. Das Fenster 2 ist zu einer Strahlrichtung des Flüssigkeitsstrahls 6 senkrecht orientiert. Eine oberhalb des Fensters 2 angeordnete, genauso orientierte Linse 7 dient zum Fokussieren des Laserstrahls 3. Das den Flüssigkeitsstrahl 6 bildende Komponentensystem (das nachfolgend näher beschrieben wird) wird in zur Strahlrichtung des Strahls 6 radialer Richtung mit einem Druck von 20 bar bis 500 bar durch die Flüssigkeitszufuhr 4 der Düseneinheit 1 zugeführt. Das Komponentensystem oder einzelne Bestandteile desselben werden der Flüssigkeitszufuhr 4 aus mindestens einem Vorratsbehälter (nicht gezeigt) zugeführt. Der oder die Vorratsbehälter sind dabei heizbar, so dass das Komponentensystem bzw. dessen Bestandteile vor der Zufuhr zur Flüssigkeitszufuhr 4 vorheizbar sind. Der erzeugte Flüssigkeitsstrahl 6 hat einen Durchmesser von etwa 25 bis 80 $\mu$m.

Ebenfalls dargestellt ist ein Substrat 8 aus Silicium mit einer Schichtdicke von 270 $\mu$m auf dem eine Oberflächenschicht 9 aus Siliciumnitrid (SiN$_x$) angeordnet ist, welche eine Schichtdicke von 70 nm hat. Bei dem in der Figur dargestellten Verfahren wird die Oberflächenschicht 9 dadurch mikrostrukturiert, dass der Flüssigkeitsstrahl 6 mit dem in diesem Flüssigkeitsstrahl 6 geführten Laserstrahl 3 über abzutragende Bereiche der Oberflächenschicht geführt wird. Dazu wird die Düseneinheit 1 von einer in der Figur nicht abgebildeten Führungsvorrichtung gehalten, welche die Düseneinheit gesteuert über die zu strukturierende Oberflächenschicht 9 führt. Dadurch, dass die hier im Flüssigkeitsstrahl 6 enthaltene Phosphorsäure und phosphorige Säure auf Siliciumnitrid eine wesentlich stärker ätzende Wirkung haben als auf Silicium (wobei ein Ätzen wiederum nahezu ausschließlich dort stattfindet, wo die Oberflächenschicht 9 aufgeheizt wird) wird die Oberflächenschicht 9 sehr sauber genau dort abgetragen, wo der Flüssigkeitsstrahl 6 entlanggeführt wird, während das Substrat 8 praktisch unbeschädigt bleibt. Ein lokales Aufheizen abzutragender Bereiche der Oberflächenschicht 9 erfolgt dabei durch den im Flüssigkeitsstrahl 6 geführten Laserstrahl 3. Wenn die Säuren beispielsweise beim Abtransport auch benachbarte Bereiche der Oberflächenschicht 9 berühren, hinterlassen sie dort nahezu keine Schäden, weil jene Bereiche nicht aufgeheizt werden. Um ein präzises Strukturieren der Oberflächenschicht 9 zu erlauben, ist die Düseneinheit 1 so ausgelegt, dass der Flüssigkeitsstrahl 6 laminar ist. In einem nicht dargestellten abschließenden Arbeitsschritt (spätere Galvanisierung, hier Ni-Galvanik) wird schließlich eine Metallschicht auf der Oberflächenschicht aufgebracht, nachdem die Oberflächenschicht 9 in geschilderter Weise lokal geöffnet worden ist. Durch das geschilderte Verfahren wird im vorliegenden Fall eine Solarzelle hergestellt.

Der Laserstrahl 3 wird in dem Flüssigkeitsstrahl 6, der einen Durchmesser von $\leq$ 100 $\mu$m hat, durch interne Totalreflexion geführt. Am Auftreffpunkt des Säurestrahls trifft ebenso der Laserstrahl 3 auf und erhitzt das SiN$_x$ der Schicht 9 lokal. Damit können an dieser Stelle die für das nasschemische Ätzen notwendigen Temperaturen erzeugt und das SiN$_x$ abgetragen werden. Da H$_3$PO$_4$ und H$_3$PO$_3$ im kalten Zustand SiN$_x$ nur extrem langsam ätzen, wird nur im Bereich der Laserstrahlung ein wesentlicher Abtrag erreicht und in den angrenzenden Bereichen der SiN$_x$-Schicht keine Veränderung erzeugt. Da die Säuren zudem Silicium erheblich langsamer als SiN$_x$ ätzen, kann einfach sicherge-

stellt werden, dass nur die SiN$_x$-Schicht und nicht das darunterliegende Silicium abgetragen wird. Damit wird die üblicherweise an das SiN$_x$ angrenzende, nur wenige Hundert Nanometer dünne Emitterschicht geschützt.

Die Verwendung eines 3-Komponenten-Systems mit ätzender Flüssigkeit, Reduktionsmittel und Metallsalz in der vorliegenden Erfindung ist jedoch nicht unbedingt notwendig. So kann in einem weiteren Ausführungsbeispiel gemäß der Figur auch lediglich ein 2-Komponenten-System ohne Metallsalz (hier ohne Nickelsalz) eingesetzt werden. Es wird somit eine Mischung aus Phosphorsäure und phosphoriger Säure eingesetzt. Hierbei wird das besagte Säuregemisch oder zumindest eine der beiden Säuren (Phosphorsäure und phosphorige Säure) in einem nicht gezeigten Vorratstank vorgeheizt und dann als Flüssigkeitsstrahl 6 zusammen mit dem Laserstrahl 3 in heißer Form auf die nitridbeschichtete Oberfläche 9 geschossen. Die Nitridschicht 9 wird hierbei in einem kombinierten Prozess aus Ablation und Ätzen abgetragen. Die durch das Vorheizen erhitzte Phosphorsäure ist in der Lage, das Siliziumnitrid 9 zu ätzen (nicht jedoch die kalte Säure). Die Gefahr eines unerwünschten Seitenätzens ist trotz des zusätzlichen Vorheizens jedoch auch hier nicht gegeben, da der Flüssigkeitsstrahl 6 aufgrund der geringen aufgebrachten Flüssigkeitsmengen relativ zur großen kalten Oberfläche der Nitridschicht 9 über die der Flüssigkeitsstrahl 6 nach seinem Auftreffen vernebelt wird, an dieser Oberfläche sehr schnell abkühlt.

In einem dritten (nicht in der Figur gezeigten) Ausführungsbeispiel wird bei der vorliegenden Erfindung vollständig auf den Einsatz des Lasers als Abtragsinstrument verzichtet. Bei einer dergestaltigen Ausgestaltungsform kann alleine das Zwei- oder Drei-Komponenten-Säuregemisch in dem laminaren Flüssigkeitsstrahl 6 auf die Nitridoberfläche 9 geschossen werden. Hierbei wird das Komponentengemisch im Vorfeld in mindestens einem Vorratstank bis auf etwa 20 °C unterhalb des Siedepunkts des Komponentengemischs erhitzt. Eine solche begrenzte Erhitzung vermeidet das Ausbilden von Siedebläschen im Flüssigkeitsstrahl 6. In diesem Ausführungsbeispiel ist dann der Nitridabtrag in der Schicht 9 alleine auf den Ätzabtrag beschränkt. Hierbei kann dann unterstützend auch der Siliziumwafer selbst auf mehrere 100 °C geheizt werden, um den Ätzprozess zu beschleunigen.

In allen vorbeschriebenen Fällen kommt es durch die Verwendung des erfindungsgemäßen Komponentensystems zur Ausbildung einer nur wenige Monolagen dicken Phosphorglasschicht auf den freigelegten Oberflächenabschnitten der Substratschicht 8. Diese Phosphorglasschicht hat den Vorteil, dass dadurch die ohnehin mit Phosphor dotierte Emitterschicht 8 punktuell höher mit Phosphor dotiert wird, was die spätere galvanische Nickelabscheidung verbessert und den Kontaktwiderstand erfindungsgemäß verringert. In diesem Zusammenhang erweist sich die phosphorige Säure als besserer Phosphor-Dotierstoff als die Phosphorsäure, da im PO$_3^{3-}$-Ion der Phosphor bereits eine geringere positive Oxidationsstufe aufweist, als im PO$_4^{3-}$-Ion, während er als Dotierstoff im Siliziumkristall eine negative Oxidationszahl aufweist. Der an der Oberfläche 8 deponierte Phosphor wird vorteilhafterweise nach der beschriebenen Bearbeitung der Oberflächenschicht 9 durch einen kurzzeitigen Hochtemperaturschritt in den Emitter hineingetrieben. Vorteilhafterweise können in der vorliegenden Erfindung das Benetzungsverhalten und die Viskosität des Komponentengemischs durch Zugabe von Tensiden und/oder Alkoholen, vor allem durch Zugabe von höherwertigen Alkoholen, wie beispielsweise Glykol oder Glycerin, beeinflusst werden. Dadurch ist die Ätzkerbenform im Nitrid 9 beeinflussbar.

Mit der in der Figur dargestellten Vorrichtung ist eine weitere erfindungsgemäße Variante realisierbar. Diese basiert auf einer Düseneinheit 1, die ein Fenster 2 zum Einkoppeln eines Laserstrahls 3 sowie eine Flüssigkeitszufuhr 4 und eine Düsenöffnung 5 umfasst. Diese Düseneinheit dient zur Erzeugung eines Flüssigkeitsstrahls 6, in den der eingekoppelte Laserstrahl 3 durch Totalreflexion geführt wird. Das Fenster 2 ist zu einer Strahlrichtung des Flüssigkeitsstrahls 6 senkrecht orientiert. Eine oberhalb des Fensters 2 angeordnete, genauso orientierte Linse 7 dient zum Fokussieren des Laserstrahls. Als den Flüssigkeitsstrahl 6 bildende Flüssigkeit wird eine einen Dotierstoff enthaltende Flüssigkeit eingesetzt z.B. Phosphorsäure. Diese wird in zur Strahlrichtung radialer Richtung mit einem Druck von 20 bis 500 bar durch die Flüssigkeitszufuhr 4 der Düseneinheit 1 zugeführt. Diese Düseneinheit ist auf eine Substratoberfläche eines Silicium-Substrates 8 gerichtet. Am Auftreffpunkt des Flüssigkeitsstrahls 9 kommt es zur Dotierung des Oberflächenbereichs.

Ergänzend kann dann in einem weiteren Verfahrensschritt eine Metallisierung durchgeführt werden, indem die Phosphorsäure gegen eine Silbercyanid- oder Silberacetat-Lösung ausgetauscht wird und so eine wenige Nanometer dünne Silberschicht auf dem dotierten Bereich aufgewachsen wird.

Es werden zwei Bearbeitungsköpfe nacheinander zum Strukturieren + Dotieren bzw. Metallisieren eingesetzt. Im ersten Bearbeitungsschritt wird Phosphorsäure als Flüssigkeit zusammen mit einem frequenzverdoppelten Nd:YAG-Laser eingesetzt, um eine lokale Hochdotierung mit Phosphor zu erreichen. Nachfolgend enthält der zweite Bearbeitungskopf eine übliche Silbergalvanik-Lösung (z.B. Silbercyanid-haltig) mit einem frequenzverdoppelten Nd:YAG-Laser. Mit diesem Bearbeitungsschritt kann eine wenige Nanometer dünne Silberschicht auf dem zuvor hochdotierten Bereich aufgewachsen werden, die in einem folgenden Galvanikschritt auf einige Mikrometer verdickt wird.

**Beispiel 1**

**Nitridstrukturierung/Dotierung und Bekeimung mit einer Lösung aus Hypophosphit, Phosphorsäure und einem Metallsalz**

In einer Ausführung der vorliegenden Erfindung werden alle drei Chemikaliensysteme aus den drei Einzelschritten vereint und deren Konzentrationen dem neuen System angepasst. Dem Konzept entgegen kommt die Tatsache, dass die Wechselwirkungen der nicht Phosphor enthaltenden Reagenzien aus den einzelnen Prozessschritten untereinander gering sind. So z. B. behindern Metall-Ionen keineswegs die Phosphorglasbildung und auch nicht die Ätzwirkung der Phosphorsäure auf das Siliziumnitrid. Hydrogenphosphate und Hypophosphit-Ionen bilden zusammen ein effektives Redoxpaar, das Metall-Ionen zu reduzieren in der Lage ist. Der niedrige pH-Wert der Lösung und die Anwesenheit der Hydrogenphosphat-Ionen verringert das Reduktionspotential des Hypophosphits, was zunächst einmal nicht unerwünscht ist, weil dadurch die Gefahr einer spontanen Zersetzung des Reaktionsbades, wie sie bei Bädern zur stromlosen Abscheidung von Nickel gegeben ist, deutlich reduziert wird.

Allerdings handelt es sich bei der hypophosphorigen Säure nur um eine sehr schwache Säure mit einem sehr niedrigen Siedepunkt. Die geringe Säurestärke der hypophosphorigen Säure sorgt allerdings dafür, dass die Protonenkonzentration nunmehr fast ausschließlich durch die Phosphorsäurekonzentration in der Lösung bestimmt wird, die ihrerseits nicht zu hoch ausfallen darf, weil damit das Reduktionspotential des Hypophosphits zu sehr absinkt, um noch Metall-Ionen reduzieren zu können. Der Konzentrationsspielraum der einzelnen Komponenten ist demnach in solch einem System nicht unbegrenzt. Der niedrige Siedepunkt der hypophosphorigen Säure erschwert darüber hinaus ihre Handhabbarkeit und erhöht die Gefahr einer allmählichen Konzentrationsverringerung im System durch Verflüchtigung dieser für das Gesamtsystem wichtigen Komponente. Sehr hohe Konzentrationen an Hypophosphit in Lösung verringern die Haltbarkeit des flüssigen Mediums, was für den technischen Einsatz ein erhebliches Problem darstellt. Das Chemikaliensystem erweist sich mit Hypophosphit als Reduktionsmittel demnach als äußerst labil, jedoch durchaus sehr effektiv, wenn keine lange Haltbarkeit der Lösung erforderlich ist.

Im vorgestellten Beispiel können unter anderem die folgenden Komponentensysteme zum Einsatz kommen:

$$[NiCl_2 \cdot 6\,H_2O] = 0{,}1 - 1 \text{ mol/L}$$

$$[NaH_2PO_2 \cdot H_2O] = 0{,}1 - 5 \text{ mol/L}$$

$$[H_3PO_4] = 0{,}5 - 5 \text{ mol/L}$$

Komplexbildner für $Ni^{2+}$ -Ionen und Puffer, z. B.: Hydroxyessigsäure mit: $[HOCH_2COOH] = 0{,}5 - 2$ mol/L

**Beispiel 2**

**Nitridstrukturierung/Dotierung und Bekeimung mit einer Lösung aus phosphoriger Säure, Phosphorsäure und einem Metallsalz**

Stabiler gegen spontane Zersetzung sind Systeme aus Phosphorsäure und phosphoriger Säure mit wasserlöslichen Nickelsalzen als Metallquellen, z.B.: Nickelchloriden $NiCl_2 \cdot x\,H_2O$, Nickelsulfaten $NiSO_4 \cdot x\,H_2O$ oder Nickelnitraten $Ni(NO_3)_2 \cdot x\,H_2O$. Der pH-Wert solcher Systeme wird mit Hilfe von Kaliumhydroxid-Lösung oder besser noch Ammoniumhydroxid-Lösung eingestellt. Er liegt in der Regel im leicht sauren Bereich.

$HPO_3^{2-}$ -Ionen aus der phosphorigen Säure und $HPO_4^{2-}$ - Ionen aus der Phosphorsäure bilden zusammen ein Redoxpaar. Das zweite Redoxpaar wird durch das Nickel in der Form $Ni^{2+}/Ni^0$ gebildet:

$$HPO_3^{2-} + 3\,OH^- \quad \longleftrightarrow \quad HPO_4^{2-} + 2H_2O + 2e^- \quad E° = -1{,}12\,V$$
$$Ni \quad \longleftrightarrow \quad Ni^{2+} + 2e^- \quad E° = -0{,}25\,V$$

In basischen Medien ist das $HPO_3^{2-}$-Ion genau wie das Hypophosphit ein starkes Reduktionsmittel, d. h. es ist dann auch in der Lage, Ionen einiger unedlerer Metalle zum elementaren Metall zu reduzieren, was jedoch nicht so spontan wie beim Hypophosophit erfolgt, aufgrund des geringeren Reduktionspotentials des Phosphit-Ions, in dem der Phosphor die Oxidationsstufe +III aufweist, gegenüber dem Hypophosphit, wo sie +I beträgt. Eine spontane Reduktion von $Ni^{2+}$-Ionen mit phosphoriger Säure wird in wässrigen Lösungen kaum beobachtet. An heißen, katalytisch wirkenden Oberflächen ist eine Oxidation des Phosphit-Ions zu Phosphat unter Reduktion von Metall-Ionen, auch denen des Nickels, hingegen ohne weiters möglich.

Phosphorige Säure hat gegenüber hypophosphoriger Säure darüber hinaus zwei weitere wesentliche Vorteile:

> 1) Sie besitzt einen deutlich höheren Siedepunkt als die hypophosphorige Säure und verflüchtigt sich daher weit weniger schnell.
> 2) Sie ist eine wesentlich stärkere Säure und somit ähnlich der Phosphorsäure ein effektiveres Ätzmedium für das Siliziumnitrid als die hypophosphorige Säure.

Thermodynamische Förderung des Redoxprozesses zur Metallabscheidung:

Das Reduktionsvermögen (die elektromotorische Kraft des $HPO_3^{2-}$ / $HPO_4^{2-}$ -Systems) einer $HPO_3^{2-}$ -Ionen enthaltenden Lösung ist abhängig von den Aktivitäten der besagten Ionen in der Lösung und vom pH-Wert der Lösung, genauer gesagt, der Hydroxid-IonenKonzentration. Dies wird aus der Nernstschen Gleichung für das System $HPO_3^{2-}$ / $HPO_4^{3-}$ ersichtlich:

$$\Delta E(HPO_3^{2-} / HPO_4^{2-}) = -1{,}12V + \frac{0{,}059}{2} \cdot \log \frac{a(HPO_4^{2-})}{a(HPO_3^{2-}) \cdot a(OH^-)^3} V$$

In verdünnten Lösungen ist die Aktivität a der einzelnen Spezies gleichzusetzen mit deren Konzentration c der jeweiligen Spezies in der Lösung. Je höher die $HPO_3^{2-}$-Ionen-Konzentration und/oder je höher der pH-Wert, desto negativer wird $\Delta E(HPO_3^{2-} / HPO_4^{2-})$, also desto mehr steigt das Reduktionsvermögen der Halbzelle an.
Die EMK einer Halbzelle ist jedoch auch über die Temperatur beeinflussbar, ersichtlich aus der der allgemeinen Form der Nernstschen Gleichung:

$$\Delta E = E° + \frac{RT}{zF} \cdot \lg \frac{a_{Ox}}{a_{Red}}$$

mit: $\Delta E$ = elektromotorische Kraft (EMK); $E°$ = Normalpotential (EMK unter Standardbedingungen); R = ideale Gaskonstante = 8,31451 $JK^{-1}mol^{-1}$; T = absolute Temperatur in Kelvin; z = Ladungsäquivalent (Anzahl ausgetauschter Elektronen pro Formeleinheit); F = Faraday-Konstante = 96485 A $\times$ s; $a_{ox}$ und $a_{Red}$ = Konzentrationen der oxidierten und der reduzierten Spezies.
Mit steigender Temperatur steigt demnach auch das Reduktionsvermögen der Halbzelle an. Der Nenner des logarithmischen Terms der NERNST'schen Gleichung wird dann relativ zum Zähler größer, weil die Aktivität der Hydroxid-Ionen in der dreifachen Potenz in den Nenner einfließt.

Kinetische Förderung des Redoxprozesses zur Metallabscheidung:

Die Beschleunigung der Reaktionsgeschwindigkeit einer chemischen Reaktion, darunter auch der hier betrachteten Redoxreaktion wird aus der Arrhenius-Beziehung ersichtlich, welche die Geschwindigkeitskonstante k einer Reaktion als eine Funktion der Temperatur beschreibt:

$$k = A \cdot e^{-\frac{E_A}{RT}}$$

mit: k = Geschwindigkeitskonstante, A = reaktionsspezifischer präexponentieller Faktor, $E_A$ = Aktivierungsenergie, R = allgemeine Gaskonstante, T = absolute Temperatur in Kelvin
Im flüssigen Lichtleiter werden beim Prozess die Konzentrationen der einzelnen Spezies so aufeinander abgestimmt, dass sie unter Standardbedingungen im gegebenen Zeitfenster von der Ansetzung der Lösung bis hin zur Bearbeitung der Oberfläche nicht miteinander reagieren. Hierzu muss die Spannung zwischen den Redox-Systemen $Ni^{2+}$ /$Ni^0$ und $HPO_3^{2-}$/$HPO_4^{2-}$ ausreichend gering gehalten werden, was über die Einstellung des pH-Wertes bzw. der Konzentrationen der beteiligten Spezies in Lösung erfolgen kann.
Wird nun die Lösung auf die vom Laserstrahl beheizte und geschmolzene Siliziumnitridoberfläche geschossen, so laufen dabei nacheinander verschiedene Prozesse ab:

1) Zunächst wird ein Teil der Schmelze durch den hohen mechanischen Impuls des Flüssigkeitsstrahls aus der Schmelze entfernt, indem er von diesem weggespült wird. Die auf diese Weise entfernte Schmelze ist über eine große aktive Oberfläche dem Ätzmedium Phosphorsäure/ phosphorige Säure ausgesetzt und wird von diesem gelöst, so dass es sich nicht wie beim trockenen Siliziumnitridabtrag mit Lasern randständig der Schnittkerbe ablagert. Dadurch entstehen sehr saubere Schnittgruben.

2) So lange eine Siliziumschmelze vorliegt, können die im Flüssigkeitsstrahl vorhandenen Phosphorquellen durch rein thermische Zersetzung den darin enthaltenen Phosphor an das Silizium abgeben; dieser wird gewissermaßen in das Silizium eingeschmolzen, ebenso ein Teil der mit dem Flüssigkeitsstrahl mitgeführten Metall-Ionen, im vorliegenden Fall, der Nickel-Ionen. Im geschmolzenen Silizium ist die Diffusionsrate des Phosphors darüber hinaus sehr hoch. Der Einbau von Phosphor erfolgt hier umso besser, je geringer dessen Oxidationsstufe ist, weil dann je weniger Elektronen vom System auf den Phosphor übertragen werden müssen, der als Dotierstoff im Siliziumkristall elektronegativerer Bindungspartner gegenüber dem Silizium ist. Durch den mechanischen Impuls des Flüssigkeitsstrahls kann die Dotier- und Metallisiermischung in die Siliziumschmelze regelrecht implantiert werden, wo sie zusammen mit der Schmelze erstarrt, dadurch eingeschlossen und schließlich in den Siliziumkristall zum Teil direkt eingebaut wird. Auf diese Weise können optional selbst bei einmaligem Überfahren der Schnittkerbe sehr hohe Dotiertiefen von mehreren $\mu$m erreicht werden, abhängig von der Schmelztiefe an der Schnittstelle. Ein weiterer Teil der Chemikalienmischung bleibt als Phosphorsilicatglasinseln unterhalb der Oberfläche eingeschlossen und kann im Rahmen eines Temperierschrittes als weitere Dotierquelle für das Silizium dienen. Das in sehr großer Menge ebenfalls lokal eingeschlossene Nickel legiert dabei lokal mit dem Silizium zu $Ni_2Si$, wodurch es zur Verringerung des Kontaktwiderstands beiträgt.

3) Aufgrund der hohen Wärmeleitfähigkeit des Siliziums, vor allem im flüssigen Zustand, in dem es metallische Eigenschaften aufweist, klingt die Temperatur des Siliziums relativ schnell ab. Dabei bildet sich auch an der Siliziumoberfläche ein Phosphorsilicatglas aus, dessen Netzwerkbildner ein dreidimensionales Netz aus Silizium- und Phosphoratomen ist, die über Sauerstoffbrücken miteinander verbunden sind. Ein statistischer Teil der Sauerstoffatome besitzt nur einen Bindungspartner und eine frei liegende Valenz mit einer negativen Ladung. Den Ladungsausgleich hierzu bilden $Ni^{2+}$-Ionen aus der Lösung, die dadurch elektrostatisch an die Oberfläche gebunden werden. Sie können bei einem weiteren Überfahrschritt aus dem Phosphorsilicatglas in die oberste Siliziumschicht diffundieren und dort Abscheidkeime für weitere Nickel-Atome bilden. Bei der Dotierung des Siliziums mit Hilfe von Phosphorsilicatglas erweist sich hingegen Phosphorsäure gegenüber phosphoriger Säure als die günstigere Phosphorquelle, weil darin alle Valenzen des Phosphors mit Sauerstoffatomen abgesättigt sind, die zur Netzwerkbildung im Glas benötigt werden.

4) Im Zuge der Abklingens der hohen Temperaturen an der Siliziumoberfläche wird auch jener Temperaturbereich durchschritten, bei dem nur noch eine thermische Aktivierung des oben genannten Redoxprozesses zwischen der phosphorigen Säure und den Nickel-Ionen in Lösung erfolgt, nicht aber ein direktes Einschmelzen der Komponenten wie zu Beginn der Prozesses. Jetzt kann durch die in der Schnittkerbe stehende Lösung eine Verdickung der Metallkeimschicht an der Oberfläche stattfinden, indem oben geschilderte Redoxreaktion lokal an der bekeimten und hoch dotierten Siliziumoberfläche abläuft.

Das Phosphorsilicatglas an den Wänden der Schnittkerbe wirkt sich als Isolator nachteilig auf den Kontaktwiderstand der Solarzelle aus, daher muss es im Zuge des Gesamtprozesses wieder entfernt werden, nachdem die Dotierung erfolgt ist. Dies kann parallel zum Dotierungs- und Bekeimungsprozess dadurch geschehen, dass der Reaktionsmischung geringe Mengen an Flusssäure beigemengt werden. In solchen Fällen kann dann jedoch die Verdickung der Keime nicht mit ein und derselben Lösung vorgenommen werden, die für die vorhergehenden Prozessschritte (Nitridabtrag, Dotierung, Bekeimung) eingesetzt wurde, weil in Anwesenheit von Flusssäure eine ausgeprägte Tendenz einer erneuten Auflösung bereits abgeschiedenen, elementaren Metalls gegeben ist. Die Verdickung der Kontakte kann in solchen Fällen im Rahmen eines nachfolgenden Schrittes vollzogen werden, bei dem mit Hilfe des LCE-Verfahrens klassische Nickellösungen zur stromlosen Abscheidung von Nickel in die Schnittkerben eingebracht und die Schnittkerben dabei lokal mit Hilfe des Lasers erwärmt werden. Die lokale Abscheidung des Metalls wird dabei durch zwei Faktoren beeinflusst: 1. die hohe Dotierung und bereits vorhandene Bekeimung der Grabenwände, die damit katalytisch wirken und 2. die thermische oder photochemische Aktivierung des Abscheidvorgangs durch den Laser.

Im vorgestellten Beispiel können unter anderem die folgenden Komponentensysteme zum Einsatz kommen:

1) pH = 6, 5 $\Rightarrow$ [OH$^-$] = 3,16 x 10$^{-7}$ mol/L

[HPO$_4$$^{2-}$] = 5 mol/L

[HPO$_3$$^{2-}$] = 10$^{-3}$ mol/L

$[Ni^{2+}] = 5 - 7$ mol/L

Die Spannung U zwischen Halbzellen Ni$^0$ ‖Ni$^{2+}$) und (HPO$_3$$^{2-}$ ‖HPO$_4$$^{2-}$) beträgt dann +0,205 V

2) pH = 4 $\Rightarrow$ [OH$^-$] = 10$^{10}$ mol/L

$[HPO_4^{2-}] = 10^{-3}$ mol/L

$[HPO_3^{2-}] = 6$ mol/L

$[Ni^{2+}] = 5$ mol/L

Die Spannung U zwischen den Halbzellen (Ni$^0$ ‖ Ni$^{2+}$) und (HPO$_3$$^{2-}$ ‖HPO$_4$$^{2-}$) beträgt hier + 0,12 V

3) pH = 6 $\Rightarrow$ [OH$^-$] = 10$^{-8}$ mol/L

$[HPO_4^{2-}] = 1$ mol/L

$[HPO_3^{2-}] = 5 \times 10^{-2}$ mol/L

$[Ni^{2+}] = 1 - 5$ mol/L

Die Spannung U zwischen den Halbzellen (Ni$^0$ ‖Ni$^{2+}$) und (HPO$_3$$^{2-}$ ‖HPO$_4$$^{2-}$) beträgt in diesem Fall + 0,10 bis +0,12 V

4) pH = 5 $\Rightarrow$ [OH$^-$] = 10$^{-9}$ mol/L

$[HPO_4^{2-}] = 1$ mol/L

$[HPO_3^{2-}] = 10^{-1}$ mol/L

$[Ni^{2+}] = 1 - 3$ mol/L

Die Spannung U zwischen den Halbzellen (Ni$^0$ ‖Ni$^{2+}$) und (HPO$_3$$^{2-}$ ‖HPO$_4$$^{2-}$) liegt hier bei +0,04 V

**Beispiel 3**

**Nitridstrukturierung / Dotierung / Bekeimung und Schadensätze mit einem Chemikaliensystem bestehend aus KOH-Lösung, Hydrogenphosphatsalz und Metallsalz**

Je nach Wahl der Laserwellenlänge können beim Prozessieren der Kontaktgräben Schäden im kristallinen Gefüge mit unterschiedlicher Eindringtiefe entstehen, die aufgrund ihres Qualität mindernden Faktors auf die elektrischen Eigenschaften der Solarzellen unerwünscht sind. Bei den BC-Solarzellen werden diese Schäden nach dem Anfertigen der Gräben durch eignen zusätzlichen Schadensätzschritt wieder entfernt, bevor der Metallisierungsschritt durchgeführt wird.

Bei der vorliegenden Erfindung kann diese Schadensätze parallel zu den drei Teilprozessen: Nitridöffnung/ Dotierung/Bekeimung erfolgen, indem das dafür verwendete Chemikaliensystem angepasst wird. An dieser Stelle sei noch einmal auf die Arbeiten von Baumann et al 2006 hingewiesen, in denen gezeigt wurde, dass mit dem LCE-Verfahren auf der Basis von KOH-Lösungen ein schädigungsfreier Abtrag von Silizium möglich ist.

Ausgehend von der Annahme, dass der Nitridabtrag auch weitgehend durch eine rein thermische Ablation des Nitrids durchführbar und eine Metallbekeimung der dotierten Siliziumoberfläche auch ohne Reduktion der Metall-Ionen mit Hilfe einer Phosphorverbindung denkbar ist, lassen sich die in den Ausführungsbeispielen 1 - 2 vorgestellten Chemikaliensysteme dahingehend modifizieren, dass die phosphorhaltigen Verbindungen ausschließlich zur Phosphordotierung eingesetzt werden. Als Phosphorquelle dient in diesem Zusammenhang ein Hydrogenphosphatsalz, z. B. Lithiumhydrogenphosphat, das in einer Kaliumhydroxid-Lösung gelöst ist. Metallquelle ist ein Nickelsalz, z..B. Nickelchlorid. Aufgrund der Tatsache, dass im basischen Bereich Ni(OH)$_2$ ausfällt, muss der Lösung noch ein Komplexbildner für die Nickel-Ionen zugefügt werden, z. B. Ammoniak, mit dem diese den in basischen Medien beständigen [Ni(NH$_3$)$_6$]$^{2+}$$_{(aq)}$-Komplex bilden. Dotierung und Bekeimung erfolgen hier wie in Ausführungsbeispiel 2 in den Punkten 1) - 3) beschrieben. Die Schadensätze wird durch Kaliumhydroxid-Ionen vorgenommen, die sich in der überstehenden Lösung in den Schnittgräben während des Prozesses befinden, während Flüssigkeitsstrahl und Laserstrahl weiter gefahren sind. Lithium-Ionen, die beim Schmelz- und Erstarrungsvorgang in den Siliziumkristall ebenfalls lokal an den Kontaktstellen eingebaut werden, reduzieren den Kontaktwiderstand der Solarzelle zusätzlich.

Die Metallkeimschicht kann in einem weiteren Prozessschritt entweder durch klassische stromlose Nickelabscheidung oder durch andere Verfahren verdickt werden, etwa mit Hilfe des Optomec®-Verfahrens.

Im vorgestellten Beispiel können unter anderem die folgenden Komponentensysteme zum Einsatz kommen:

Gehalt der KOH-Lösung: 2 - 20 Gew.-%
$[Li_2HPO_4]$ = 0,1 - 5 mol/L
$[Ni^{2+}]$ = 1 mol/L
ca. 20 mL konz. $NH_3$-Lsg/L Lösung

**Beispiel 4**

**Nitridstrukturierung/Dotierung und Schadensätze ohne Metallbekeimung mit Chemikaliensystemen aus: Phosphorsäure/ Salpetersäure/ Flusssäure.**

Wird auf eine Metallbekeimung im Zuge der Nitridstrukturierung und gleichzeitiger Dotierung verzichtet und diese erst in einem anschließenden Schritt durchgeführt, so kann als Schadensätzreagenz ein Gemisch aus $HF/HNO_3$ eingesetzt werden, das der Phosphorsäure zugesetzt wird. $HF/HNO_3$ hat gegenüber KOH als Schadensätzreagenz den Vorteil einer viel höheren Ätzrate und isotroper Ätzeigenschaften.

Im vorgestellten Beispiel können unter anderem die folgenden Komponentensysteme zum Einsatz kommen:

Gehalt der Phosphorsäure-Lösung: 80 - 87 Gew.-%
HF (49%) : 35 mL/L Lösung
$HNO_3$ (70%) : 15 mL/L Lösung

Sämtliche hier in den Beispielen beschriebenen Gesamtprozesse können natürlich.durch eine vereinfachte Flüssigkeitsstrahlzusammensetzung auf ihre Teilprozesse reduziert werden. So z. B. kann eine Siliziumnitridstrukturierung mit gleichzeitiger Dotierung auch ohne Metallisierung erfolgen, wenn das Metallsalz der Lösung nicht zugefügt wird.

Die vorbeschriebenen Ausführungsbeispiele stellen vorteilhafte Ausführungsformen der vorliegenden Erfindung dar. Die Erfindung ist jedoch nicht auf diese Ausführungsbeispiele beschränkt:

- Wie bereits angedeutet, kann das erfindungsgemäße Verfahren mit Hilfe eines kombinierten Flüssigkeits-Laserstrahls 3, 6 oder auch lediglich mit einem laminaren Flüssigkeitsstrahl 6 ohne Einkopplung von Laserlicht eingesetzt werden, um die Passivierungsschicht 9 des Siliziums abzutragen. Somit dient entweder der Laser über seine heizende Wirkung als Initiator für die vorbeschriebene chemische Ätzreaktion oder der Flüssigkeitsstrahl 6 bewirkt dies selbst durch seine vorgeschaltete Aufheizung, bevor er auf die zu bearbeitende Probe geschickt wird.
- Neben dem in den vorstehenden Beispielen angegebenen Reduktionsmittel (phosphorige Säure) können auch andere Reduktionsmittel für Metallionen eingesetzt werden. Hierzu eignen sich insbesondere schweflige Säure ($H_2SO_3$), salpetrige Säure ($HNO_2$) oder auch aus den Bereich der organischen Chemie Aldehyde (letztere werden im Zuge des beschriebenen Prozesses dann zu Carbonsäuren aufoxidiert, welche wiederum gleichzeitig tensidische Eigenschaften entfalten können, was zur gezielten Beeinflussung des Benetzungsverhaltens der Lösungen an der Nitridschicht 9 genutzt werden kann).
- Alternativ zu der genannten Phosphorsäure und phosphorigen Säure können auch weitere Säuren des Phosphors oder andere Säuren eingesetzt werden. Auch der Einsatz von phosphorhaltigen Flüssigkeiten, wie z.B. Phosphorylchlorid ($POCl_3$) oder Phosphortrichlorid ist möglich).
- Außer Passivierungsschichten 9 des Siliziums aus Siliziumnitrid können auch andere Passivierungsschichten, wie beispielsweise $SiO_2$-Schichten bearbeitet werden, indem die Ätzmedien-Zusammensetzung entsprechend an die Schichten angepasst wird.
- Anstelle des Phosphors können auch Verbindungen anderer Elemente der fünften Hauptgruppe des Periodensystems als Dotierstoffe verwendet werden. Beispielsweise können Stickstoff-, Arsen- oder Antimonverbindung eingesetzt werden. Auch die Verwendung von Dotierstoffen aus anderen Haupt- oder Nebengruppen des Periodensystems ist möglich.

Mit der in der Figur schematisch dargestellten Vorrichtung kann eine Ausführung des erfindungsgemäßen Verfahrens realisiert werden, bei dem der auf die Oberflächenschicht 9 gerichtete Laserstrahl 3 zum lokalen Aufheizen der Oberflächenschicht 9 über deren abzutragende Bereiche geführt wird, bevor jeweils der Flüssigkeitsstrahl 6 über diese Bereiche geführt wird. Zusätzlich kann auch der Aerosol-Strahl geheizt und dadurch die Oberflächenschicht 9 indirekt aufgeheizt werden. Dazu kann die im Flüssigkeitsstrahl 6 enthaltene Phosphorsäure und/oder ein im Aerosol-Strahl enthaltenes Gas vorgewärmt werden.

**Patentansprüche**

1. Verfahren zur Präzisionsbearbeitung von Substraten, bei dem ein auf eine Substratoberfläche gerichteter und ein Bearbeitungsreagenz enthaltender Flüssigkeitsstrahl über die zu bearbeitenden Bereiche des Substrats geführt wird, wobei in den Flüssigkeitsstrahl ein Laserstrahl eingekoppelt wird,
**dadurch gekennzeichnet, dass** bei der Präzisionsbearbeitung mit einem Dotierstoff als Bearbeitungsreagenz eine zumindest bereichsweise Emitterdiffusion eines Dotierstoffs in einen Silizium-Wafer als Substrat durchgeführt wird.

2. Verfahren nach Anspruch 1,
**dadurch gekennzeichnet, dass** der Laserstrahl durch Totalreflexion im Flüssigkeitsstrahl geführt wird.

3. Verfahren nach einem der vorhergehenden Ansprüche,
**dadurch gekennzeichnet, dass** der Dotierstoff ausgewählt ist aus der Gruppe bestehend aus Phosphorsäure, Phosphorige Säure, Lösungen von Phosphaten und Hydrogenphosphaten, Borax, Borsäure, Boraten und Perboraten, Borverbindungen, Galliumverbindungen und Mischungen hiervon.

4. Verfahren nach einem der vorhergehenden Ansprüche,
**dadurch gekennzeichnet, dass** die Emitterdiffusion mit einem $H_3PO_4$, $H_3PO_3$ und/oder $POCl_3$ enthaltenden Flüssigkeitsstrahl, in den ein Laserstrahl eingekoppelt ist, durchgeführt wird.

5. Verfahren nach einem der vorhergehenden Ansprüche,
**dadurch gekennzeichnet, dass** vor der Präzisionsbearbeitung mindestens eine dielektrische Schicht, insbesondere ausgewählt aus der Gruppe bestehend aus $SiN_x$, $SiO_2$, $SiO_x$, $MgF_2$, $TiO_2$ und $SiC_x$ auf dem Substrat zur Passivierung abgeschieden wird.

6. Verfahren nach Anspruch 5,
**dadurch gekennzeichnet, dass** bei der Präzisionsbearbeitung eine Mikrostrukturierung der dielektrischen Schicht erfolgt.

7. Verfahren nach einem der Ansprüche 5 oder 6,
**dadurch gekennzeichnet, dass** die dielektrische Schicht durch Behandlung mit einem trockenen Laser oder einem wasserstrahlgeführten Laser oder einem ein Ätzmittel enthaltenden flüssigkeitsstrahlgeführtem Laser geöffnet wird und/oder durch Behandlung mit dem das Bearbeitungsreagenz enthaltenden flüssigkeitsstrahlgeführten Laser geöffnet wird und das Bearbeitungsreagenz ein Ätzmittel ist, das auf die dielektrische Schicht eine stärker ätzende Wirkung als auf das Substrat besitzt, und/oder durch Behandlung mit dem das Bearbeitungsreagenz enthaltenden flüssigkeitsstrahlgeführten Laser geöffnet wird und dass das Bearbeitungsreagenz ein Ätzmittel ist, mit dem Schäden im Substrat nachgeätzt werden, wobei das Ätzmittel insbesondere ausgewählt ist aus der Gruppe bestehend aus $H_3PO_4$, $H_3PO_3$, $PCl_3$, $PCl_5$, $POCl_3$, KOH, HF/$HNO_3$, Chlorverbindungen und Schwefelsäure.

8. Verfahren nach einem der Ansprüche 6 oder 7,
**dadurch gekennzeichnet, dass** die Mikrostrukturierung und die Dotierung simultan durchgeführt wird oder dass im Anschluss an die Mikrostrukturierung eine Dotierung des mikrostrukturierten Silizium-Wafers erfolgt und das Bearbeitungsreagenz einen Dotierstoff enthält oder dass nur bereichsweise eine Dotierung im Substrat erzeugt wird, anschließend auf der Substratoberfläche befindliche Flüssigkeit eingetrocknet und das Substrat thermisch behandelt wird, so dass das Substrat eine schwache Flächendotierung und eine eingetriebene hohe Lokaldotierung aufweist.

9. Verfahren nach einem der vorhergehenden Ansprüche,
**dadurch gekennzeichnet, dass** bei der Präzisionsbearbeitung zusätzlich eine zumindest bereichsweise Aufbringung einer metallhaltigen Keimschicht auf einem Silizium-Wafer, insbesondere durch Nickel-Galvanisierung, Nickel-Laser-Verfahren, Inkjet-Verfahren, Aerosol-Verfahren, Aufdampfen, Lasersintern, Siebdruck und/oder Tampondruck erfolgt.

10. Verfahren nach einem der Ansprüche 6 bis 9, **dadurch gekennzeichnet, dass** die Mikrostrukturierung, die Dotierung und die Aufbringung der Keimschicht nacheinander oder parallel durchgeführt werden.

11. Verfahren nach einem der Ansprüche 6 bis 10, **dadurch gekennzeichnet, dass** nach der Aufbringung der Keimschicht eine Rückseitenkontaktierung, insbesondere durch Aufdampfen, Sputtern oder durch lasergefeuerte Rückseitenkontaktierung (LFC) aufgebracht wird.

12. Verfahren nach einem der Ansprüche 9 bis 11, **dadurch gekennzeichnet, dass** nach der Aufbringung der Keimschicht eine thermische Behandlung, insbesondere bei Temperaturen von 100 °C bis 900 °C für 0,5 bis 30 min und insbesondere durch Laser-Annealing mit Punkt- oder Linienfokus und/oder eine Verdickung der Keimschicht, insbesondere durch galvanische Abscheidung, z.B. von Ag, oder durch stromlose Abscheidung, z.B. von Cu, erfolgt.

**Claims**

1. Method for precision processing of substrates in which a liquid jet which is directed towards a substrate surface and comprises a processing reagent is guided over the regions of the substrate to be processed, a laser beam being coupled into the liquid jet, **characterised in that**, during the precision processing with a doping agent as processing reagent, an emitter diffusion of a doping agent into a silicon wafer as substrate is implemented at least in regions.

2. Method according to claim 1,
   **characterised in that** the laser beam is guided by total reflection in the liquid jet.

3. Method according to one of the preceding claims,
   **characterised in that** the doping agent is selected from the group consisting of phosphoric acid, phosphorous acid, solutions of phosphates and hydrogen phosphates, borax, boric acid, borates and perborates, boron compounds, gallium compounds and mixtures hereof.

4. Method according to one of the preceding claims,
   **characterised in that** the emitter diffusion is implemented with a liquid jet which comprises $H_3PO_4$, $H_3PO_3$ and/or $POCl_3$ and into which a laser beam is coupled.

5. Method according to one of the preceding claims,
   **characterised in that**, before the precision processing, at least one dielectric layer, in particular selected from the group consisting of $SiN_x$, $SiO_2$, $SiO_x$, $MgF_2$, $TiO_2$ and $SiC_x$, is deposited on the substrate for passivation.

6. Method according to claim 5,
   **characterised in that** microstructuring of the dielectric layer is effected during the precision processing.

7. Method according to one of the claims 5 or 6,
   **characterised in that** the dielectric layer is opened by treatment with a dry laser or with a water jet-guided laser or a liquid jet-guided laser which comprises an etching agent and/or is opened by treatment with the liquid jet-guided laser which comprises the processing reagent and the processing reagent is an etching agent which has a more strongly etching effect on the dielectric layer than on the substrate and/or is opened by treatment with the liquid jet-guided laser which comprises the processing reagent and **in that** the processing reagent is an etching agent with which damage in the substrate is re-etched, the etching agent being selected in particular from the group consisting of $H_3PO_4$, $H_3PO_3$, $PCl_3$, $PCl_5$, $POCl_3$, KOH, HF/HNO$_3$, chlorine compounds and sulphuric acid.

8. Method according to one of the claims 6 or 7,
   **characterised in that** the microstructuring and the doping is implemented simultaneously or **in that** doping of the microstructured silicon wafer is effected subsequent to the microstructuring and the processing reagent comprises a doping agent or **in that** doping is produced only in regions in the substrate, subsequently liquid situated on the substrate surface is dried up and the substrate is treated thermally so that the substrate has a weak surface doping and a penetrating high local doping.

9. Method according to one of the preceding claims,
   **characterised in that**, during the precision processing, in addition application of a metal-containing nucleation layer on a silicon wafer is effected at least in regions, in particular by nickel electroplating, nickel laser methods, ink jet methods, aerosol methods, vapour coating, laser sintering, screen printing and/or tampon printing.

10. Method according to one of the claims 6 to 9,
**characterised in that** the microstructuring, the doping and the application of the nucleation layer are implemented in succession or in parallel.

11. Method according to one of the claims 6 to 10,
**characterised in that**, after application of the nucleation layer, a rear-side contacting, in particular by vapour coating, sputtering or by laser-fired rear-side contacting (LFC), is applied.

12. Method according to one of the claims 9 to 11,
**characterised in that**, after application of the nucleation layer, a thermal treatment, in particular at temperatures of 100°C to 900°C, is effected for 0.5 to 30 min and in particular by laser annealing with point or line focus, and/or thickening of the nucleation layer is effected, in particular by galvanic deposition, e.g. of Ag, or by currentless deposition, e.g. of Cu.

**Revendications**

1. Procédé pour l'usinage de précision de substrats, dans lequel un jet de liquide, dirigé vers une surface du substrat et contenant un réactif d'usinage, est guidé sur les zones à usiner du substrat, dans lequel un faisceau laser est injecté dans le jet de liquide, **caractérisé en ce que**, lors de l'usinage de précision avec un dopant en tant que réactif d'usinage, on procède, au moins par zones, à une diffusion de l'émetteur d'un dopant dans une tranche de silicium servant de substrat.

2. Procédé selon la revendication 1, **caractérisé en ce que** le faisceau laser est guidé par réflexion totale dans le jet de liquide.

3. Procédé selon l'une des revendications précédentes, **caractérisé en ce que** le dopant est choisi dans le groupe consistant en l'acide phosphorique, l'acide phosphoreux, les solutions de phosphates et d'hydrogénophosphates, le borax, l'acide borique, les borates et les perborates, les composés du bore, les composés du gallium et les mélanges de ceux-ci.

4. Procédé selon l'une des revendications précédentes, **caractérisé en ce que** la diffusion de l'émetteur est mise en oeuvre avec un jet de liquide contenant du $H_3PO_4$, du $H_3PO_3$ et/ou du $POCl_3$, jet de liquide dans lequel est injecté un faisceau laser.

5. Procédé selon l'une des revendications précédentes, **caractérisé en ce que**, avant l'usinage de précision, au moins une couche diélectrique, en particulier choisie dans le groupe consistant en $SiN_x$, $SiO_2$, $SiO_x$, $MgF_2$, $TiO_2$ et $SiC_x$, est déposée sur le substrat pour passivation.

6. Procédé selon la revendication 5, **caractérisé en ce que**, lors de l'usinage de précision, il se produit une microstructuration de la couche diélectrique.

7. Procédé selon l'une des revendications 5 ou 6, **caractérisé en ce que** la couche diélectrique est ouverte par traitement avec un laser sec ou un laser guidé avec un jet d'eau ou un laser guidé avec un jet de liquide et contenant un agent de gravure, et/ou est ouverte par traitement avec le laser guidé avec le jet d'eau et contenant le réactif d'usinage, et le réactif d'usinage est un agent de gravure, qui sur la couche diélectrique possède un effet de gravure plus fort que sur le substrat, et/ou est ouverte par traitement avec le laser guidé avec un jet de liquide contenant le réactif d'usinage, et **en ce que** le réactif d'usinage est un agent de gravure, à l'aide duquel les dommages dans le substrat sont regravés, dans lequel l'agent de gravure est choisi en particulier dans le groupe consistant en $H_3PO_4$, $H_3PO_3$, $PCl_3$, $PCl_5$, $POCl_3$, KOH, $HF/HNO_3$, les composés du chlore et l'acide sulfurique.

8. Procédé selon l'une des revendications 6 ou 7, **caractérisé en ce que** la microstructuration et le dopage sont réalisés simultanément, ou que, suite à la microstructuration, on procède à un dopage de la tranche de silicium microstructurée, et le réactif d'usinage contient un dopant, ou qu'un dopage dans le substrat n'est produit que par zones, puis le liquide se trouvant sur la surface du substrat est séché, et le substrat est soumis à un traitement thermique, de telle sorte que le substrat présente un dopage de surface faible et un dopage local implanté élevé.

**9.** Procédé selon l'une des revendications précédentes, **caractérisé en ce que**, lors de l'usinage de précision, on procède en outre à une application, au moins par zones, d'une couche de germination contenant un métal sur une tranche de silicium, en particulier par galvanisation au nickel, par le procédé nickel-laser, par le procédé jet d'encre, par le procédé aérosol, par métallisation sous vide, par frittage laser, par sérigraphie et/ou par impression au tampon.

**10.** Procédé selon l'une des revendications 6 à 9, **caractérisé en ce que** la microstructuration, le dopage et l'application de la couche de germination sont effectués successivement ou parallèlement.

**11.** Procédé selon l'une des revendications 6 à 10, **caractérisé en ce que**, après application de la couche de germination, un contact face arrière est appliqué en particulier par métallisation sous vide, pulvérisation cathodique ou par un contact face arrière (LFC) réalisé par un recuit laser.

**12.** Procédé selon l'une des revendications 9 à 11, **caractérisé en ce que**, après application de la couche de germination, on procède à un traitement thermique, en particulier à des températures de 100 à 900°C pendant 0,5 à 30 mn et en particulier par un recuit laser avec foyer ponctuel ou linéaire, et/ou à un épaississement de la couche de germination, en particulier par un dépôt galvanique, par exemple d'Ag, ou par un dépôt sans courant, par exemple de Cu.

**Figur**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20030062126 A1